(19) Europäisches Patentamt

European Patent Office

Office européen des brevets

(11) Veröffentlichungsnummer: **0 224 231 B1**

(12) **EUROPÄISCHE PATENTSCHRIFT**

(45) Veröffentlichungstag der Patentschrift: **12.05.93**

(21) Anmeldenummer: **86116235.2**

(22) Anmeldetag: **24.11.86**

(51) Int. Cl.⁵: **H01L 31/02**, H01L 31/18, H01J 37/32

(54) **Verfahren zur Herstellung einer Dünnschichtssolarzelle.**

(30) Priorität: **28.11.85 DE 3542111**

(43) Veröffentlichungstag der Anmeldung:
**03.06.87 Patentblatt 87/23**

(45) Bekanntmachung des Hinweises auf die
Patenterteilung:
**12.05.93 Patentblatt 93/19**

(84) Benannte Vertragsstaaten:
**DE ES FR IT**

(56) Entgegenhaltungen:
**EP – A – 0 062 302**
**EP – A – 0 091 998**

**MICROELECTRONIC ENGINEERING, Band 3,
Nr. 1/4, Dezember 1985, Seiten 419 – 425, Elsevier Science Publishers B.V., Amsterdam,
NL; L.M. BUCHMANN et al.: "Mass spectrometry for controlling etch processes of silicon containing layers"**

(73) Patentinhaber: **Nukem GmbH
Industriestrasse 13
W – 8755 Alzenau(DE)**

(72) Erfinder: **Hewig, Gert, Dr.
Kastanienweg 15a
W – 8755 Alzenau(DE)**
Erfinder: **Schum, Berthold
Bornweg 44
W – 6455 Biebergemünd(DE)**
Erfinder: **Wörner, Jörg, Dr.
Philipp – Reis – Strasse 16
W – 6451 Grosskrotzenburg(DE)**

(74) Vertreter: **Stoffregen, Hans – Herbert, Dr.
Dipl. – Phys.
Patentanwalt, Salzstrasse 11 a, Postfach 21
44
W – 6450 Hanau (Main) 1 (DE)**

**THIN SOLID FILMS, Band 67, 1980, Seiten 309–320, Elsevier Sequoia S.A.,Lausanne, CH; G. TURBAN et al.: "Mass spectrometry of a silane glow discharge during plasma de-position of a–Si: H films"**

**THE CONFERENCE RECORD OF THE 9th IEEE PHOTOVOLTAIC SPECIALISTS CONFEREN-CE, 2.–4. Mai 1972, Seiten 106–110, Silver Spring, US; K.BOGUS et al.: "High efficiency Cu2S–CdS–solar cells with improved ther-mal stability"**

EP 0 224 231 B1

**Beschreibung**

Zur Herstellung einer Dünnschichtsolarzelle nach dem Oberbegriff des Anspruchs 1. Glimmprozesse werden unter anderem bei der Herstellung von Solarzellen eingesetzt, wobei hier sowohl das Ausbilden als auch das Abtragen von Schichten in Frage kommt. Ersteres ist zum Beispiel aus der DE−OS 21 52 895 bekannt, bei der der Wirkungsgrad einer Dünnschicht−Solarzelle des Typs Kupfersulfid−Cadmiumsulfid dadurch erhöht wird, daß auf die Kupfersulfidschicht eine weitere Kupfer enthaltende Schicht aufgetragen wird, die dünn gegenüber der Kupfersulfidschicht ist. Dabei kann das Kupferinventar für die zusätzliche Schicht durch Reduktion des Kupfersulfids an der Oberfläche erzeugt werden, und zwar durch Behandlung im Glimmfeld in einer Wasserstoffatmosphäre. Das Abtragen von Schichten zur Herstellung von funktionstüchtigen Solarzellen ist zum Beispiel im Zusammenhang mit Inversionsschicht−Solarzellen bekannt. Glimmprozesse werden aber auch zum Beispiel bei der Reinigung von Reaktionsräumen eingesetzt, die zur Herstellung von a−Si−Solarzellen benutzt werden. Hier dient die Glimmentladung dazu, in dem Reaktionsraum z.B. vorhandenes Polysilan oder Polymere der Dotiergase wie $PH_3$ und $B_2H_6$ durch Wegätzen mittels Fluor−Verbindungen zu reinigen. Aber auch das Säubern von Gläsern kann in einem Glimmprozeß durchgeführt werden.

Die Prozeßführung von Glimmprozessen, wie beispielsweise Dauer und eingestellter Gasdruck, beruht typischerweise auf Erfahrungswerten. Daher ist immer wieder feststellbar, daß die Glimmprozesse nicht zu den gewünschten Ergebnissen führen.

Glimmprozesse sind der Literaturstelle "Thin Solid Films, 67 (1980) 309−320" zu entnehmen, wobei bei der Abscheidung von a−Si:H−Filmen während einer Glimmentladung das Autreten stabiler Reaktionsprodukte, die durch Reaktion von Gasspezies untereinander auftreten, in Abhängigkeit von z.B. Druck oder Leistung massenspektrometrisch verfolgt wird.

Um beim Ätzen von Phosphorsilikat−Gläsern festzustellen, ob der Ätzvorgang abgeschlossen ist, wird nach der EP−A 0 062 302 das Verschwinden einer charakteristischen Spektrallinie beobachtet.

Aufgabe der vorliegenden Erfindung ist es, ein Verfahren der eingangs genannten Art so auszubilden, daß eindeutig Rückschlüsse auf die Reaktion der bei der Glimmentladung vorhandenen Ionen mit dem Reaktanden möglich sind, so daß Rückschlüsse auf die Güte der erfolgten Reaktion zwischen den Ionen und dem Reaktanden unmittelbar gewonnen werden können. Es soll folglich ein Glimmprozeß reproduzierbar durchführbar sein.

Die Aufgabe wird durch die dem Anspruch 1 zu entnehmenden Maßnahmen gelöst. Erfindungsgemäß wird demzufolge der zeitliche Verlauf der Glimmentladung verfolgt, also der Glimmprozeß an sich, bei dem im Plasma erzeugte Ionen mit dem Reaktanden reagieren.

Da der zeitliche Verlauf bestimmt wird, lassen sich unmittelbar während des Prozeßablaufes − selbstverständlich auch nach dem Prozeß− Aussagen treffen, ob der Reaktand im gewünschten Umfang mit den Ionen reagiert hat, damit jener die gewünschte chemische Veränderung erfahren hat. Durch das erfindungsgemäße Verfahren kann folglich der spezifische Aufbau des Reaktanden optimal berücksichtigt werden.

Insbesondere wird der Glimmprozeß derart eingestellt, daß sich das Verhältnis der Fläche des Bereiches I zu der des Bereichs II wie $F_I : F_{II} = (2,5 \pm 0,5) : 1$ verhält (bei auszutauschender Wasserstoffatmoshäre).

Weiterbildungen der Erfindung sind den Ansprüchen 2 bis 6 zu entnehmen.

Die Erfindung wird nachstehend anhand der Zeichnung näher erläutert.

Es zeigen:

Fig. 1    den zeitlichen Verlauf des Partialdruckes von $H_2S$ bei einer der Erfindung gehorchenden Herstellung einer Kupfersulfid/Cadmiumsulfid−Dünnschichtsolarzelle im Glimmprozeß,

Fig. 2    der Partialdruck von $H_2S$ bei einer der Erfindung nicht gehorchenden Herstellung einer Kupfersulfid/Cadmiumsulfid−Dünnschichtsolarzelle im Glimmprozeß und

Fig. 3    eine Vorrichtung zur Herstellung einer Kupfersulfid/Cadmiumsulfid−Dünnschichtsolarzelle im Glimmprozeß.

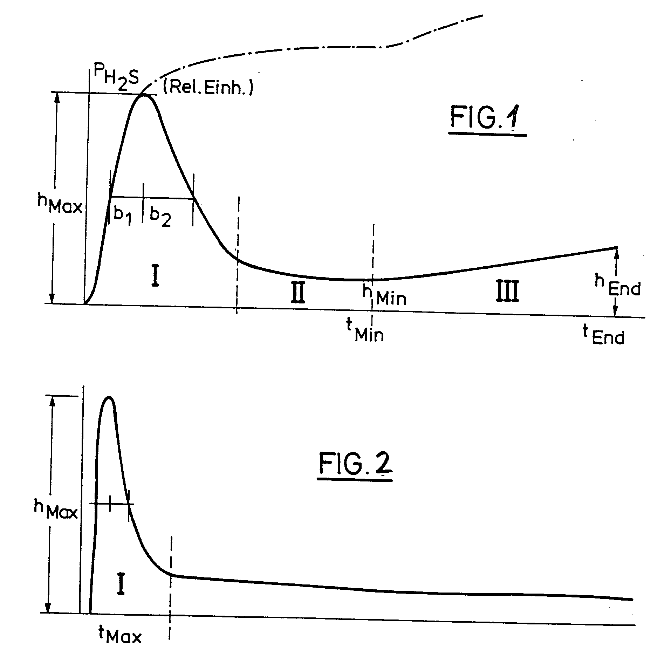

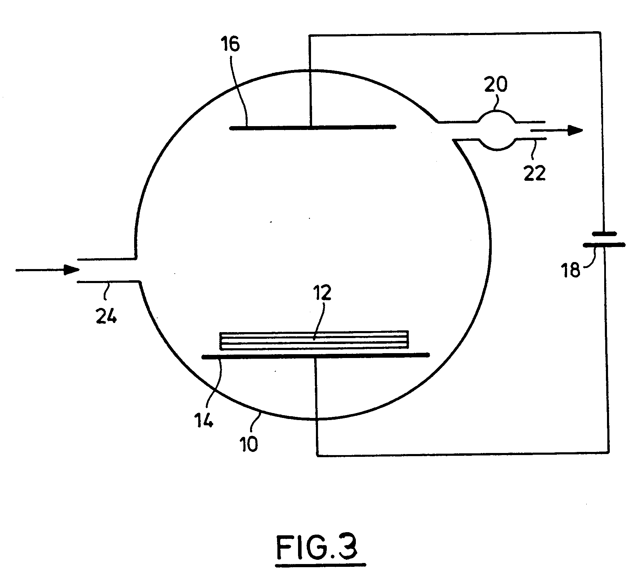

Anhand der Fig. 1 bis 3 soll ein Glimmprozeß beschrieben werden, der zu der Herstellung von Kupfersulfid/Cadmiumsulfid−Dünnschichtsolarzellen benutzt wird, um eine hochstöchiometrische, einer Degradation nicht unterliegende Kupfersulfidschicht zu erzeugen.

So wird in einem Glimmkessel (10) eine zumindest ein Substrat, einen elektrisch leitenden Rückkontakt sowie eine Cadmiumsulfid− und Kupfersulfidschicht aufweisende Solarzelle (12) im Bereich einer Anode (14) angeordnet, der eine Kathode (16) zugeordnet ist. Zwischen Anode (14) und Kathode (16) befindet sich eine Spannungsquelle (18). Um den Glimmprozeß durchzuführen, wird der Glimmkessel (10) zunächst auf einen Druck von in etwa $10^{-6}$ mbar ($10^{-4}$ Pa) evakuiert. Anschließend erfolgt ein kontrolliertes Fluten mit

3

Wasserstoff, und zwar in einem Umfang, daß sich ein konstanter Druck von in etwa 0,5 mbar (50 Pa) einstellt. Sodann wird der Glimmprozeß bei einer angelegten Spannung von 300 Volt und einer Stromstärke durchgeführt, die zu einer Stromdichte von 10 $\mu A/cm^2$ Halbleiterschicht führt. Durch die Wasserstoffradikale bzw. $H^-$ − Ionen erfolgt zunächst eine vollständige Reduktion von auf der Kupfersulfidschicht vorhandenem Kupferoxid. Gleichzeitig werden überschüssige Schwefelionen aus der Kupfersulfidschicht entfernt. Diese Reduktion läßt sich durch den Partialdruck des $H_2S$ erkennen, der mittels eines Massenspektrometers (20) festgestellt wird. Dabei befindet sich das Massenspektrometer (20) in einer Auslaßleitung (22). Über die Auslaßleitung (22) wird dem Glimmkessel (10) fortwährend Wasserstoffgas entnommen, dem über die Leitung (24) im gleichen Umfang Wasserstoffgas zugeführt wird. Dabei ist das Durchströmen derart gewählt, daß der Kessel (10) vorzugsweise zweimal pro Minute vollständig mit neuem Wasserstoffgas gefüllt wird, ohne daß sich hierbei der Innendruck von in etwa 0,5 mbar (50 Pa) ändert.

Erfolgt eine der Erfindung gehorchende Reduktion der Kupferoxidschicht und der Kupfersulfidschicht zur Ausbildung einer hochstöchiometrischen, $Cu_2S$ − Schicht, ist an Hand des Partialdrucks des Schwefel − wasserstoffs, der mit dem Massenspektrometer (20) bestimmt wird, feststellbar. Ein entsprechender Verlauf ist der Fig. 1 zu entnehmen. Dieser Bereich ist mit I bezeichnet. Man erkennt, daß die Kurve steil ansteigt, ein Maximum durchläuft und anschließend steil abfällt. Dabei ist das Maximum in Bezug auf die Halb − wertsbreite der Kurve zu kürzerer Zeit hin verschoben. An dem Bereich II nimmt der $H_2S$ − Partialdruck leicht ab, um sodann ein Minimum zu erreichen. In diesem Bereich wird die Oberflächenschicht der $Cu_2S$ − Schicht durch Adsorption von reduzierenden Spezies ($H^-$) in eine Inversionsschicht umgewandelt, durch die die dem Wirkungsgrad einer Solarzelle bestimmenden Ladungsträger, also Elektronen oder Löcher, hin − durchtunneln könne, wohingegen für Ionen dies nicht möglich ist.

Sobald der Bereich II abgeschlossen ist, steigt der Partialdruck des $H_2S$ leicht an. In diesem Bereich wird dem Kupfersulfid Schwefel unter Bildung von $H_2S$ entzogen. Hierdurch bildet sich elementares Kupfer, das anschließend durch einen Temperprozeß kontrolliert in eine Kupferoxidschicht umgewandelt wird, durch die die Ladungsträger von der hochohmigen $Cu_2S$ − Schicht verbessert zu einem Frontkontakt geleitet werden.

Läuft der Glimmprozeß nicht ordnungsgemäß, also nicht der Erfindung gehorchend ab, so ergeben sich die zuvor beschriebenen Bereiche I, II und III nicht. Vielmehr ergibt sich der Kurvenverlauf, der der Fig. 2 zu entnehmen ist. Man erkennt, daß der Bereich I im Vergleich zu einem ordnungsgemäß verlaufenden Glimmprozeß kürzer, das Maximum in Bezug auf die Halbwärtsbreite der Kurve nicht zu der kürzeren Zeit hin verschoben ist. Eine getrennte Ausbildung der Bereich II und III ergibt sich nicht. Vielmehr bilden diese eine Einheit neben dem Bereich I. Die Flächen $F_I$ : ($F_{II}$ + $F_{III}$) zeigen ein Verhältnis von in etwa 1 : 2. Aus einer entsprechenden Kurve kann demzufolge geschlossen werden, daß die im Glimmprozeß hergestellte Kupfersulfid/Cadmiumsulfid − Solarzelle bezüglich der Kupfersulfidschicht nicht hochstöchiometrisch und eine Inversionsschicht nicht in dem Umfang ausgebildet ist, daß die Semipermeabilität bezüglich der Ladungsträger bzw. der Ionen gewährleistet ist. Aus dem Vergleich der Fig. 1 und 2 ergibt sich ferner, daß sich die Flächen des Bereichs I bei ordnungsgemäß und nicht ordnungsgemäß durchgeführtem Glimmpro − zeß verhalten in etwa wie:

$$\frac{F_I \text{ ordnungsgemäß}}{F_I \text{ nicht ordnungsgemäß}} = \frac{3,25 \ +/- \ 0,75}{1}$$

Durch dieses Verhältnis wird auch deutlich, daß bei ordnungsgemäß ablaufendem Prozeß im gesamten $Cu_{2-x}S$ − Material eine Reduktion stattgefunden hat, wodurch im nicht ordnungsgemäßen Prozeß lediglich eine Reduktion der Oberflächenschicht erfolgt ist.

Ferner ist in den Fig. 1 und 2 in gestrichelter Darstellung angedeutet, wie der $H_2S$ − Partialdruck verläuft, wenn die Atmosphäre des Glimmkessels während des Glimmens nicht ausgetauscht wird.

Durch die erfindungsgemäße Lehre kann demzufolge mit einfachen Mitteln ein Glimmprozeß kontrolliert gesteuert werden, um die mit dem Glimmprozeß beabsichtigten Reaktionen optimal ablaufen lassen zu können.

Die genaue Festlegung der Stöchiometrie spielt bei allen Verbindungshalbleitern eine wesentliche Rolle. Die Stöchiometrie bestimmt die Anzahl der gebildeten Ladungsträger. Der Absorptionskoeffizient des Materials ist stöchiometrieabhängig. Die Anzahl der Ladungsträger bestimmt die spezifische Leitfähigkeit des Materials, da diese von der Dotierung sehr stark abhängt, und somit den Transport der gebildeten Ladungsträger. Sie muß im Betrieb (hohe Ladungsträgerdichte, Temperaturerhöhung) konstant bleiben, d.h.

sie darf keiner Verarmung oder Anreicherung von Ionen der Festkörper unterliegen. Diese drei stöchiome – trieabhängigen Faktoren bestimmten ganz wesentlich den Wirkungsgrad und die Stabilität (Wirkungsgrad beim Betrieb über lange Zeit) der Solarzellen.

Deshalb werden bei der $Cu_{2-x}S/CdS$ – Zelle mehrere Reduktions – und Oxidationsprozesse durchge – führt, ebenso wie bei der $CuInSe_2/CdS$ – Solarzelle. Auch bei der Feineinstellung des spezifischen Wider – standes von TCO – Schichten sind solche kombinierten Reduktions – /Oxidationsprozesse bekannt.

**Patentansprüche**

1. Verfahren zur Herstellung einer $Cu_{2-x}S/CdS$ – Dünnschichtsolarzelle mit $0 \leq x \leq 1$, wobei die $Cu_{2-x}S$ – Schicht als Reaktand in einem Reaktionsraum einer Glimmentladung in Wasserstoffatmosphäre aus – gesetzt wird,
**gekennzeichnet durch,**
die weiteren Verfahrensschritte

a) Reduktion in der Glimmentladung von auf der $Cu_{2-x}S$ – Schicht vorhandenem $Cu_{2-z}0$ mit $0 \leq z \leq$ 1 und überschüssigen Schwefel – Ionen aus der $Cu_{2-x}S$ – Schicht bis zur Gewinnung einer hoch – stöchiometrischen $Cu_2S$ – Schicht,

b) Ausbilden einer Inversionsschicht auf und aus der hochstöchiometrischen $Cu_2S$ – Schicht durch Adsorption von negativ geladenen Wasserstoffatomen ($H^-$ – Ionen) aus der Wasserstoffatmosphäre der Glimmentladung,

c) Reduktion der freien Oberfläche der Inversionsschicht zu elementarem Kupfer,

wobei der zeitliche Verlauf der Bildung von durch Reaktion mit dem Reaktanden entstehenden stabilen Reaktionsprodukten massenspektrometrisch außerhalb des Reaktionsraumes verfolgt wird, und wobei der zeitliche Verlauf des Glimmprozesses derart eingestellt wird, daß der durch die Reduktion der $Cu_{2-x}S$ – Schicht entstehende $H_2S$ – Partialdruck gemessen bei kontinuierlich auszutauschender Was – serstoffatmosphäre zunächst steil ansteigt und nach Durchlaufen eines Maximums wieder steil abfällt (Bereich I), wobei die Zeitdover des Anstiegs kürzer als diejenige des Abfalls gewählt ist, daß sich anschließend eine allmähliche Verringerung des $H_2S$ – Partialdrucks bis zu einem Minimum (Bereich II) ergibt, und daß anschließend der $H_2S$ – Partialdruck nahezu kontinuierlich ansteigt (Bereich III).

2. Verfahren nach Anspruch 1,
**dadurch gekennzeichnet,**
daß die Reduktion in der positiven Säule der Glimmentladung durchgeführt wird.

3. Verfahren nach Anspruch 1,
**dadurch gekennzeichnet,**
daß die Glimmentladung zur Bildung der Inversionsschicht in einem evakuierten Raum erfolgt, der zunächst auf einen Druck p mit $p \approx 10^{-6}$ mbar ($10^{-4}$ Pa) eingestellt wird, und daß der Raum anschließend mit Wasserstoff zur Erzielung eines Drucks von 0,5 mbar (50 Pa) geflutet wird, um die Glimmentladung durchzuführen.

4. Verfahren nach Anspruch 3,
**dadurch gekennzeichnet,**
daß der Glimmprozeß bei einer Stromdichte von 10 $\mu A/cm^2$ Halbleiterschicht bei einer zwischen den Elektroden angelegten Spannung von 300 V erfolgt.

5. Verfahren nach Anspruch 1,
**dadurch gekennzeichnet,**
daß die Wasserstoffatmosphäre des Glimmraumes während des Glimmprozesses ohne Änderung des Innendrucks ausgetauscht wird.

6. Verfahren nach Anspruch 5,
**dadurch gekennzeichnet,**
daß der Austausch vorzugsweise in etwa 2 mal pro Minute erfolgt.

7. Verfahren nach Anspruch 1,
**dadurch gekennzeichnet,**
daß sich das Verhältnis der Fläche des Bereichs I zu der des Bereichs II wie

$$F_I : F_{II} = (2,5 +/- 0,5) : 1$$

verhält.

**Claims**

1. A method for manufacturing a $Cu_{2-x}S/CdS$ thin−film solar cell with $0 \leqq x \leqq 1$, in which the $Cu_{2-x}S$ layer − being the reactant − is subjected to a corona discharge in a reaction chamber containing a hydrogen atmosphere,
**characterized in that**
it involves the additional steps of
   a) reduction, by the corona discharge, of $Cu_{2-z}O$ in the $Cu_{2-x}S$ layer with $0 \leqq z \leqq 1$ and surplus sulfur ions from the $Cu_{2-x}S$ layer, ultimately yielding a highly stoichiometric $Cu_2S$ layer;
   b) formation of an inversion layer on and from the highly stoichiometric $Cu_2S$ layer by adsorption of negatively charged hydrogen atoms ($H^-$ ions) from the hydrogen atmosphere of the corona discharge; and
   c) reduction of the free surface of the inversion layer to elementary copper;
with the process of formation over time being monitored outside the reaction chamber by mass spectrometry of stable reaction products that result from reaction with the reactant, and
with the course of the corona discharge over time being set in such a way that the partial $H_2S$ pressure resulting from reduction of the $Cu_{2-x}S$ layer, measured in a continuously exchanged hydrogen atmosphere, first increases sharply and then drops off again sharply after traversing a certain maximum level (zone I), the duration of the rise being set to be less than that of the fall; this is then followed by a gradual diminishment of the partial $H_2S$ pressure until it reaches a certain minimum level (zone II), with the partial $H_2S$ pressure subsequently rising at a nearly constant rate (zone III).

2. Method according to claim 1,
**characterized in that**
the reduction is performed in the positive column of the corona discharge.

3. Method according to claim 1,
**characterized in that**
the corona discharge for formation of the inversion layer takes place in an evacuated chamber that is initially set to a pressure p with $p \approx 10^{-6}$ mbars ($10^{-4}$ Pa), and that the chamber is subsequently flooded with hydrogen to obtain a pressure of 0.5 mbar (50 Pa) for performance of the corona discharge.

4. Method according to claim 3,
**characterized in that**
the corona discharge process takes place at a current density of 10 $\mu A/cm^2$ of semiconductor layer at an applied voltage of 300 V between the electrodes.

5. Method according to claim 1,
**characterized in that**
the hydrogen atmosphere of the reaction chamber is exchanged during the discharge process without changing its internal pressure.

6. Method according to claim 5,
**characterized in that**
the exchange is preferably carried out at a rate of approximately twice per minute.

7. Method according to claim 1,
**characterized in that**
the ratio of the surface area of zone I to that of zone II is as follows:

$$F_I:F_{II} = (2.5 \pm 0.5):1$$

**Revendications**

1. Procédé de fabrication d'une cellule solaire en film mince $Cu_{2-x}S/CdS$ avec $0 \leq x \leq 1$, dans laquelle la couche $Cu_{2-x}S$ est exposée comme réactant dans une chambre réactionnelle d'une décharge électrique en atmosphère d'hydrogène, procédé caractérisé par les étapes de procédé suivantes :

   a) Réduction dans la décharge électrique de $Cu_{2-z}O$ avec $0 \leq z \leq 1$ existant sur la couche $Cu_{2-x}S$ et des ions soufre excédentaires de la couche $Cu_{2-x}S$, jusqu'à obtention d'une couche hautement stoechiométrique $Cu_2S$,

   b) Formation d'une couche d'inversion sur et à partir de la couche $Cu_2S$ hautement stoechiométrique par adsorption d'atomes d'hydrogène chargés négativement (ions $H^-$) provenant de l'atmosphère de la décharge électrique,

   c) Réduction de la surface libre de la couche d'inversion à du cuivre élémentaire,

   procédé dans lequel

   – la variation dans le temps de la formation de produits de réaction stables naissants de la réaction avec le réactant est suivie par spectrométrie de masse en dehors de l'espace réactionnel, et

   – la variation dans le temps du procédé de décharge électrique est ajustée de façon que la pression partielle de $H_2S$ prenant naissance par suite de la réduction de la couche de $Cu_{2-x}S$ et mesurée dans l'atmosphère d'hydrogène à remplacer continuellement, monte d'abord de façon rapide et après passage par un maximum chute à nouveau rapidement (zone I), la durée de la montée étant plus courte que celle de la descente, qu'il se produit ensuite une réduction graduelle de la pression partielle de $H_2S$ jusqu'à un minimum (zone II) et qu'ensuite la pression partielle de $H_2S$ monte à peu près continuellement (zone III).

2. Procédé selon la revendication 1, caractérisé en ce que la réduction est effectuée dans la colonne positive de la décharge électrique.

3. Procédé selon la revendication 1, caractérisé en ce que la décharge électrique a lieu pour la formation de la couche d'inversion dans un espace où on a fait un vide, qui est d'abord ajusté à une pression $p \approx 10^{-6}$ mbar ($10^{-4}$ Pa) et en ce qu'ensuite l'espace est rempli d'hydrogène destiné à obtenir une pression de 0,5 mbar (50 Pa) pour réaliser la décharge électrique.

4. Procédé selon la revendication 3, caractérisé en ce que le procédé par décharge électrique a lieu avec une densité de courant de 10 $\mu$A/cm$^2$ de couche de semi–conducteur à une tension de 300 V placée entre les électrodes.

5. Procédé selon la revendication 1, caractérisé en ce que l'atmosphère d'hydrogène de la chambre de décharge est renouvelée pendant le procédé de décharge sans modifier la pression interne.

6. Procédé selon la revendication 5, caractérisé en ce que le renouvellement se fait de préférence environ deux fois par minute.

7. Procédé selon la revendication 1, caractérisé en ce que le rapport de la surface de la zone I à celle de la zone II s'établit comme suit :

   $F_I:F_{II} = (2,5 +/- 0,5) : 1$

$P_{H_2S}$ (Rel.Einh.)

FIG.1

$h_{Max}$

$b_1$ | $b_2$

I

II

$h_{Min}$

III

$h_{End}$

$t_{Min}$

$t_{End}$

FIG.2

$h_{Max}$

I

$t_{Max}$

8

## FIG.3